# EUROPEAN PATENT SPECIFICATION

(11) **EP 3 703 078 B1**
(45) Date of publication and mention of the grant of the patent: **24.08.2022**
(21) Application number: 18871563.5
(22) Date of filing: 26.10.2018
(51) Int. Cl.: H01B 1/04, B32B 1/08, C01B 32/168, H01B 5/08, H01B 7/00, B32B 5/02, B32B 27/12, B32B 27/30, B32B 27/32, B32B 27/34, C01B 32/158, H01B 7/36, B32B 27/36, B32B 27/40, B82Y 30/00

(54) **COATED CARBON NANOTUBE ELECTRIC WIRE, METHOD FOR PRODUCING SAME, AND METHOD FOR DETECTING IDENTIFICATION MARK**
MIT KOHLENSTOFFNANORÖHRCHEN BESCHICHTETER ELEKTRISCHER DRAHT, VERFAHREN ZU SEINER HERSTELLUNG UND VERFAHREN ZUR ERKENNUNG EINER IDENTIFIKATIONSMARKE
FIL ÉLECTRIQUE REVÊTU DE NANOTUBES DE CARBONE, SON PROCÉDÉ DE PRODUCTION ET PROCÉDÉ DE DÉTECTION DE MARQUE D'IDENTIFICATION

(30) Priority: 26.10.2017 JP 2017207666
(43) Date of publication of application: 02.09.2020
(73) Proprietor: Furukawa Electric Co., Ltd., Chiyoda-ku Tokyo 100-8322 (JP)
(72) Inventor: AIZAWA, Hideki, Tokyo 100-8322 (JP); YAMAZAKI, Satoshi, Tokyo 100-8322 (JP); YAMASHITA, Satoshi, Tokyo 100-8322 (JP); HATAMOTO, Kenji, Tokyo 100-8322 (JP)
(74) Representative: Gunzelmann, Rainer
(86) International application number: PCT/JP2018/039972
(87) International publication number: WO 2019/083030

(56) References cited:
- EP-A1- 1 577 902
- EP-A1- 1 958 213
- EP-A2- 1 251 036
- WO-A1-2009/137722
- JP-A- 2001 023 451
- JP-A- 2001 023 451
- JP-A- 2002 313 165
- JP-A- 2003 261 869
- JP-A- 2003 261 869
- JP-A- 2005 100 756
- JP-A- 2005 100 756
- JP-A- 2007 181 805
- JP-A- 2009 196 829
- JP-A- 2009 196 829
- JP-A- 2011 524 604
- JP-A- 2014 017 124
- JP-A- 2014 017 124
- JP-U- 3 017 649

## Description

### Technical Field

The present invention relates to a coated carbon nanotube electric wire formed by coating a carbon nanotube wire formed by a plurality of carbon nanotubes with an insulating material, a method for producing the same, and a method for detecting an identification mark.

### Background Art

Carbon nanotube (hereinafter, sometimes referred to as "CNT") is a material having various characteristics, and its application to many fields is expected.

For example, the CNT is a three-dimensional mesh structure including a tubular single layer having a hexagonal lattice mesh structure or a plurality of layers arranged substantially coaxially, and is lightweight and superior in various characteristics such as electroconductivity, heat conductivity, and mechanical strength. However, it is not easy to form the CNT into a wire, and there are few techniques utilizing the CNT as wire.

For example, in order to further improve the electroconductivity of a CNT material, there has been proposed a carbon nanotube material in which an electroconductive deposit made of metal or the like is formed at an electrical bonding point of adjacent CNT wires, and, as disclosed, this carbon nanotube material can be applied to a wide range of uses (Patent Literature 1).

On the other hand, as a power line or a signal line in various fields such as automobiles and industrial apparatuses, there is used an electric line composed of a core wire including one or a plurality of wires, and an insulating coating which coats the core wire. As the material of the wire forming the core wire, there is usually employed copper or copper alloy from the viewpoint of electrical characteristics. In recent years, however, aluminum or aluminum alloy is proposed from the viewpoint of weight reduction. For example, the specific gravity of aluminum is approximately 1/3 of the specific gravity of copper, and the electric conductivity of the aluminum is approximately 2/3 of the electric conductivity of copper (In the case where pure copper is a 100% IACS reference, pure aluminum is approximately 66% IACS), and to cause the same electric current to flow through an aluminum wire as through a copper wire, it is necessary for the sectional area of the aluminum wire to be approximately 1.5 times that of the copper wire. Even if an aluminum wire of such a large sectional area is employed, the use of an aluminum wire is advantageous from the viewpoint of weight reduction since the mass of the aluminum wire is approximately half the mass of a pure copper wire.

Further, as the performance and function of automobiles, industrial apparatuses, etc. become increasingly higher, the number of various electric apparatuses, control apparatuses, etc. arranged increases. At the same time, the number of wiring members used in these apparatuses and the amount of heat generated from the core wires tend to increase. In view of this, there is a demand for an improvement in terms of the heat dissipation characteristics of the electric wire without impairing the insulation property of the insulating coating. On the other hand, in order to improve the fuel efficiency of a moving body such as an automobile for environmental purposes, there is a demand for weight reduction of the wire.

Further, conventionally, to identify the kind and use of an electric wire, an identification mark has been imparted to the outer surface of the electric wire. For example, in an automobile, various electric components and electric apparatuses are mounted, and a wire harness is routed to transmit power, control signal, etc., between the electric components (electric apparatuses). In the various electric wires, there is imparted an identification mark for each electric circuit for identification of a corresponding electric wire.

The carbon nanotube wire can exhibit a superior electroconductivity equal to that of a wire formed of copper, aluminum or the like. However, unlike a metal core wire, a carbon nanotube wire using carbon nanotube exhibits anisotropy in heat conduction, and heat is preferentially conducted in the longitudinal direction as compared with the radial direction. That is, unlike the metal wire in specifications, the carbon nanotube wire requires an identification method in accordance with the use of the wire, etc.

WO 2009/197722 A1 describes a material that can take advantage of the characteristics of carbon nanotubes, so that a cable made carbon nanotubes can be processed for end use applications.

JP 2005 100 756 A describes a cable with a color band on a sheath covering the cable core. The color band is applied in a spiral form.

EP 1 958 213 A1 describes an apparatus for coloring an electrical wire to improve a visibility and design of the electrical wire. The apparatus includes a coloring device for ejecting a liquid coloring material to an outer surface of the electrical wire.

JP 2014 017124 A describes a cable including a conductor enclosed by an insulation coat. A fluorescent identification information is disposed on the insulation coat.

JP 2001 023451 A describes an electric wire including marks varying in color irreversibly in response to temperature.

EP 1 251 036 A2 describes a wire harness including an IC tag of a non/contact type mounted thereon.

JP 2003 231 869 A describes phosphor particles having excellent moisture resistance by surface treatment and having excellent dispersibility without causing a decrease in initial luminescence intensity.

JP 2009 196 829 A describes a core-shell structure silica nanoparticle in which a functional compound such as a fluorescent dye compound or a light-absorbing dye compound is confined in a communication hole inside a silica particle of a porous core.

EP 1 577 902 A describes an electric wire including an electrically conductive core wire made of metal, an insulating coating which coats the core wire, a mark formed on an outer surface of the coating, and a coating layer which coats the mark.

### Document List

### Patent Literature(s)

Patent Literature 1: Japanese Laid-Open Patent Publication No. 2015-523944

### Summary of Invention

### Technical Problem

It is an object of the present invention to achieve an improvement in terms of the identifiability of a coated carbon nanotube electric wire.

### Solution to Problem

The present invention provides a coated carbon nanotube electric wire and a method for producing a coated carbon nanotube electric wire as set out in independent claims.
[1] A coated carbon nanotube electric wire comprising: a carbon nanotube wire including one or a plurality of carbon nanotube aggregates formed by a plurality of carbon nanotubes; and an insulating coating layer coating the carbon nanotube wire,
   wherein the insulating coating layer has an identification mark.
[2] The coated carbon nanotube electric wire according to [1], wherein the identification mark is situated at a portion of an outer surface of the insulating coating layer; and
   on the outer surface of the insulating coating layer, color of the identification mark is different from color of a portion other than the identification mark.
[3] The coated carbon nanotube electric wire according to [1] or [2], wherein the carbon nanotube wire is a twisted wire; and the identification mark indicates a twisting direction of the twisted wire.
[4] The coated carbon nanotube electric wire according to any one of [1] to [3], wherein the identification mark is spirally situated on an outer surface of the insulating coating layer.
[5] The coated carbon nanotube electric wire according to [1], wherein the identification mark is an identification mark situated on an entire outer surface of the insulating coating layer and having single color.
[6] The coated carbon nanotube electric wire according to [1] or [2], wherein the identification mark is set in accordance with at least one characteristics value selected from a group consisting of heat conductivity and electric conductivity of the coated carbon nanotube electric wire.
[7] The coated carbon nanotube electric wire according to [1], [2], or [6], wherein the identification mark includes a capsule or capsules.
[8] The coated carbon nanotube electric wire according to [7], wherein the capsule or capsules includes a fluorescent substance or an electrically conductive material.
[9] The coated carbon nanotube electric wire according to [1], wherein the identification mark is composed of a core portion including a fluorescent substance, and a shell portion including silica.
[10] The coated carbon nanotube electric wire according to [1], wherein the identification mark includes a tag.
[11] The coated carbon nanotube electric wire according to [1], wherein the identification mark includes a material changing in color in accordance with a temperature change or a stress change in the coated carbon nanotube electric wire.
[12] The coated carbon nanotube electric wire according to [1], wherein the identification mark includes a magnetic material.
[13] The coated carbon nanotube electric wire according to any one of [1] to [4], wherein the identification mark includes a fluorescent substance; and
   the coated carbon nanotube electric wire is a submarine cable, an underground cable, an aircraft cable, or a space cable.
[14] The coated carbon nanotube electric wire according to any one of [1], [2], and [6] to [12], wherein on an outer surface of the insulating coating layer, the identification mark is situated at at least one end portion in a longitudinal direction of the coated carbon nanotube electric wire.
[15] The coated carbon nanotube electric wire according to any one of [1], [2], and [6] to [12], wherein the identification mark has an annular configuration encircling an outer surface of the insulating coating layer.
[16] The coated carbon nanotube electric wire according to any one of [1] to [15], wherein a refractive index n_{D} of a material forming the insulating coating layer is less than 1.5, and a film thickness of the insulating coating layer divided by a wire diameter of the carbon nanotube wire is less than 0.2.
[17] The coated carbon nanotube electric wire according to any one of [1] to [15], wherein a total luminous transmittance of a material forming the insulating coating layer as specified in JIS 7375:2008 is less than 90%, and a film thickness of the insulating coating layer divided by a wire diameter of the carbon nanotube wire is less than 0.2.
[18] The coated carbon nanotube electric wire according to any one of [1] to [17], wherein the carbon nanotube wire includes the plurality of carbon nanotube aggregates, and a full-width at half maximum Δθ in azimuth angle in azimuth plot based on small-angle X-ray scattering indicating an orientation of the plurality of carbon nanotube aggregates is 60° or less.
[19] The coated carbon nanotube electric wire according to any one of [1] to [18], wherein a peak top q value at (10) peak of scattering intensity based on X-ray scattering indicating density of the plurality of carbon nanotubes is 2.0 nm⁻¹ or more and 5.0 nm⁻¹ or less, and a full-width at half maximum Δq is 0.1 nm⁻¹ or more and 2.0 nm⁻¹ or less.
[20] A plurality of coated carbon nanotube electric wires, each of the coated carbon nanotube electric wires including a carbon nanotube wire including one or a plurality of carbon nanotube aggregates formed by a plurality of carbon nanotubes, and an insulating coating layer coating the carbon nanotube wire,
   wherein the insulating coating layers of the plurality of coated carbon nanotube electric wires have identification marks or colors that are different from each other.
[21] A method for producing a coated carbon nanotube electric wire comprising: twisting a coated carbon nanotube electric wire including a twisted wire of two or more carbon nanotube wires including one or a plurality of carbon nanotube aggregates formed by a plurality of carbon nanotubes, an insulating coating layer coating the carbon nanotube wires, and an identification mark indicating a twisting direction of the twisted wire on an outer surface of the insulating coating layer in a twisting direction indicated by the identification mark.
[22] A method for detecting an identification mark, wherein a light is applied to a coated carbon nanotube electric wire including a twisted wire of two or more carbon nanotube wires including one or a plurality of carbon nanotube aggregates formed by a plurality of carbon nanotubes, an insulating coating layer coating the carbon nanotube wire, and an identification mark indicating a twisting direction of the twisted wire on an outer surface of the insulating coating layer and including a fluorescent substance; and fluorescent light emitted from the fluorescent substance is detected, whereby the identification mark is detected.

### Effects of Invention

The insulating coating layer has an identification mark, whereby the coated carbon nanotube electric wire can exhibit superior identifiability.

### Brief Description of Drawings

[Fig. 1] An explanatory view of a coated carbon nanotube electric wire according to one embodiment.
[Fig. 2] An explanatory view of a carbon nanotube wire used for a coated carbon nanotube electric wire according to one embodiment.
[Fig. 3] Portion (a) is a diagram illustrating one example of a two-dimensional scattering image of a scattering vector q of a plurality of carbon nanotube aggregates by SAXS; and portion (b) is a graph illustrating one example of an azimuth angle - scattering intensity of an arbitrary scattering vector q the origin of which is the position of a transmission X-ray in the two-dimensional scattering image.
[Fig. 4] A graph illustrating relationship between the q value and intensity by WAXS of a plurality of carbon nanotubes forming a carbon nanotube aggregate.
[Fig. 5] An explanatory view of a coated carbon nanotube electric wire having an identification mark according to one embodiment.
[Fig. 6] An explanatory view of a coated carbon nanotube electric wire having an identification mark according to one embodiment.
[Fig. 7] An explanatory view of a coated carbon nanotube electric wire having an identification mark according to one embodiment.

### Description of Embodiments

### 1. Coated Carbon Nanotube Electric Wire

In the following, a coated carbon nanotube electric wire according to one embodiment will be described with reference to the drawings.

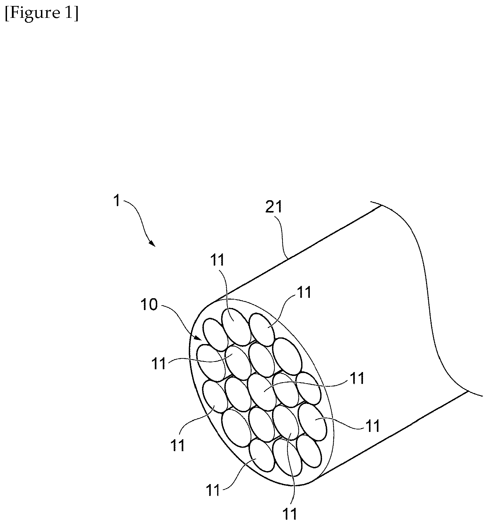

As shown in Fig. 1, in a coated carbon nanotube electric wire (hereinafter sometimes referred to as a coated CNT electric wire) 1 according to one embodiment, a peripheral surface of a carbon nanotube wire (hereinafter sometimes referred to as a CNT wire) 10 is coated with an insulating coating layer 21. That is, the coating with the insulating coating layer 21 is effected along the longitudinal direction of the CNT wire 10. In the coated CNT electric wire 1, the entire peripheral surface of the CNT wire 10 is coated with the insulating coating layer 21. Further, in the coated CNT electric wire 1, the insulating coating layer 21 is in direct contact with the peripheral surface of the CNT wire 10. In this case, the coated CNT electric wire 1 is equipped with the carbon nanotube wire including one or a plurality of carbon nanotube aggregates formed by a plurality of carbon nanotubes, and the insulating coating layer coating the carbon nanotube wire. Although not shown in Fig. 1, the insulating coating layer 21 has an identification mark. While in Fig. 1 the CNT wire 10 is an element wire (solid wire) including one CNT wire 10, a plurality of CNT wires 10 may be twisted together into a twisted wire. By forming the CNT wire 10 as a twisted wire, it is possible to adjust the equivalent circle diameter and the sectional area of the CNT wire 10 as appropriate. In the case where the coated CNT electric wire 1 has a twisted wire obtained through the twisting of a plurality of CNT wires 10, the insulating coating layer 21 may be formed so as to coat each CNT wire 10 (solid wire), and then the CNT wires 10 after the formation of the insulating coating layers 21 may be twisted together into a twisted wire, or a plurality of CNT wires 10 may be twisted into a twisted wire, and then the insulating coating layer 21 may be formed so as to coat the twisted wire. In the case where the CNT wire 10 is a twisted wire, the identification mark may indicate the twisting direction of the twisted wire. The identification mark may be situated on a part or the whole of the outer surface of the insulating coating layer 21, or the entire insulating coating layer 21 may be the identification mark.

In another embodiment, there may be provided a plurality of coated carbon nanotube electric wires equipped with a carbon nanotube wire including one or a plurality of carbon nanotube aggregates formed by a plurality of carbon nanotubes, and an insulating coating layer coating the carbon nanotube wire. In this case, each of the insulating coating layers forming the plurality of coated carbon nanotube electric wires has identification marks or colors different from each other. The plurality of coated carbon nanotube electric wires may be in the form of a bundle of a plurality of coated carbon nanotube electric wires, or an aggregate of a plurality of coated carbon nanotube electric wires. Generally speaking, the carbon nanotube wire is of a smaller wire diameter than that of a metal wire, so that depending on its embodiment, there are cases where the identifiability as the identification mark is low. Further, the carbon nanotube wire can undergo a change in characteristics depending on the manner of twisting, material, etc., so that there are cases where it is rather difficult to specify its characteristics from the section and thickness of the carbon nanotube wire as in the case of a metal wire. In contrast, in the case where, regarding a plurality of coated carbon nanotube electric wire, the respective insulating coating layers have identification marks or colors different from each other, it is possible to visually recognize each identification mark with high identifiability. Thus, in the plurality of coated carbon nanotube electric wires, by providing different identification marks on the insulating coating layers in accordance with the respective coated carbon nanotube electric wires, it is possible to recognize the characteristics, etc. of each coated carbon nanotube electric wire.

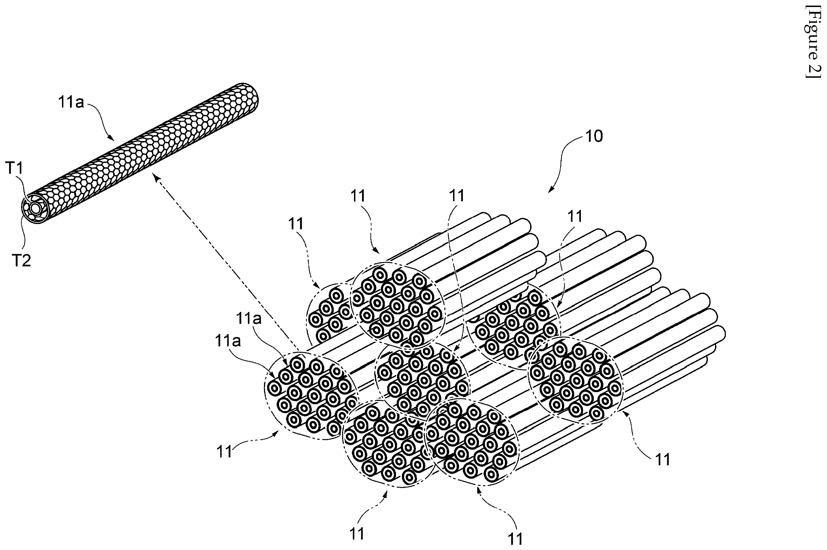

As shown in Fig. 2, the CNT wire 10 is formed by bundling one or a plurality of carbon nanotube aggregates (hereinafter sometimes referred to as the CNT aggregates) 11 formed by a plurality of CNTs 11a each having a layer structure of one layer or more. Here, the CNT wire means a CNT wire having a CNT proportion of 90 mass% or more. In the calculation of the CNT proportion in the CNT wire, the plating and dopant are excluded. In Fig. 2, the CNT wire 10 is of a structure in which a plurality of CNT aggregates 11 are bundled together. The longitudinal direction of the CNT aggregates 11 constitutes the longitudinal direction of the CNT wire 10. Thus, the CNT aggregate 11 is of a linear configuration. The plurality of CNT aggregates 11 in the CNT wire 10 are substantially in alignment in the longer axis direction thereof. Thus, the plurality of CNT aggregates 11 in the CNT wire 10 are oriented. There are no particular restrictions regarding the equivalent circle diameter of the CNT wire 10 which is an element wire. For example, it is 0.01 mm or more and 4.0 mm or less. There are no particular restrictions regarding the equivalent circle diameter of the CNT wire 10 which is a twisted wire. For example, it is 0.1 mm or more and 15 mm or less.

The CNT aggregate 11 is a bundle of CNTs 11a having a layer structure of one layer or more. The longitudinal direction of the CNTs 11a forms the longitudinal direction of the CNT aggregate 11. The plurality of CNTs 11a of the CNT aggregate 11 are arranged so as to be substantially in alignment in the longer axis direction thereof. Thus, the plurality of CNTs 11a of the CNT aggregate 11 are oriented. The equivalent circle diameter of the CNT aggregate 11 is, for example, 20 nm or more and 1000 nm or less, and, more typically, 20 nm or more and 80 nm or less. The width dimension of the outermost layer of the CNT 11a is, for example, 1.0 nm or more and 5.0 nm or less.

The CNT 11a forming the CNT aggregate 11 is a tubular body of a single-layer structure or a multi-layer structure. They are respectively referred to as SWNT (single-walled nanotube) and MWNT (multi-walled nanotube). For the sake of convenience, Fig. 2 only shows a CNT 11a of a double-layer structure. However, the CNT aggregate 11 may include a CNT having a layer structure of three layers or more or a CNT having a layer structure of a single layer, and may be formed by a CNT having a layer structure of three layers or more or a CNT having a layer structure of a single layer.

In the CNT 11a of the two-layer structure, there is adopted a three-dimensional mesh structure in which two tubular bodies T1 and T2 having a hexagonal lattice mesh structure are arranged substantially coaxially, and it is called DWNT (Double-walled nanotube). The hexagonal lattice which is the component unit is a six-membered ring at the apex of which a carbon atom is arranged, and other six-membered rings are continuously connected adjacent thereto.

The nature of the CNT 11a depends on the chirality of the tubular body. Chirality is roughly divided into an armchair type, zigzag type, and chiral type, and the armchair type exhibits metallic behavior, the zigzag type exhibits semiconductor-like and semi-metallic behavior, and the chiral type exhibits semiconductor-like and semi-metallic behavior. Thus, the electroconductivity of the CNT 11a greatly differs depending on which type of chirality the tubular body exhibits. In the CNT aggregate 11 forming the CNT wire 10 of the coated CNT electric wire 1, from the viewpoint of a further improvement in terms of electroconductivity, it is preferable to increase the proportion of the armchair type CNT 11a exhibiting metallic behavior.

On the other hand, as is known, by doping the CNT 11a of the chiral type exhibiting semiconductor-like behavior with a substance (exotic element) having electron donating property or electron accepting property, the chiral type CNT 11a exhibits metallic behavior. In an ordinary metal, through doping with an exotic element, scattering of conductive electrons occurs in the metal, resulting in a reduction in electroconductivity. Similarly, in the case where the CNT 11a exhibiting metallic behavior is doped with an exotic element, a reduction in electroconductivity is caused.

In this way, from the viewpoint of electroconductivity, the doping effect with respect to the CNT 11a exhibiting metallic behavior and the CNT 11a exhibiting semiconductor-like behavior is in a tradeoff relationship, so that theoretically speaking, it is preferable to separately prepare the CNT 11a exhibiting metallic behavior and the CNT 11a exhibiting semiconductor-like behavior, and to combine them after performing doping processing solely on the CNT 11a exhibiting semiconductor-like behavior. However, in the existing producing method, it is difficult to selectively prepare the CNT 11a exhibiting metallic behavior and the CNT 11a exhibiting semiconductor-like behavior, and the preparation is effected in a state in which the CNT 11a exhibiting metallic behavior and the CNT 11a exhibiting semiconductor-like behavior are mixed with each other. Thus, in order to further improve the electroconductivity of the CNT wire 10 including a mixture of the CNT 11a exhibiting metallic behavior and the CNT 11a exhibiting semiconductor-like behavior, it is preferable to select a CNT 11a layer structure in which doping processing with an exotic element/molecule is effective.

For example, a CNT of a small number of layers such as the two-layer structure or the three-layer structure exhibits relatively higher electroconductivity than a CNT of a larger number of layers, and when doping processing is applied, the doping effect is the highest in a CNT of the two-layer structure or the three-layer structure. Thus, from the viewpoint of further improving the electroconductivity of the CNT wire 10, it is preferable to increase the proportion of CNT having the two-layer structure or the three-layer structure. More specifically, the proportion of the CNT having the two-layer structure or the three-layer structure with respect to the entire CNT is preferably 50 number % or more, and, more preferably, 75 number % or more. The proportion of the CNT having the two-layer structure or the three-layer structure can be calculated by observing and analyzing the section of the CNT aggregate 11 by a transmission electron microscope (TEM), and measuring the number of layers of each of 100 CNTs.

Hereafter, the orientation of the CNT 11a and the CNT aggregate 11 in the CNT wire 10 will be described.

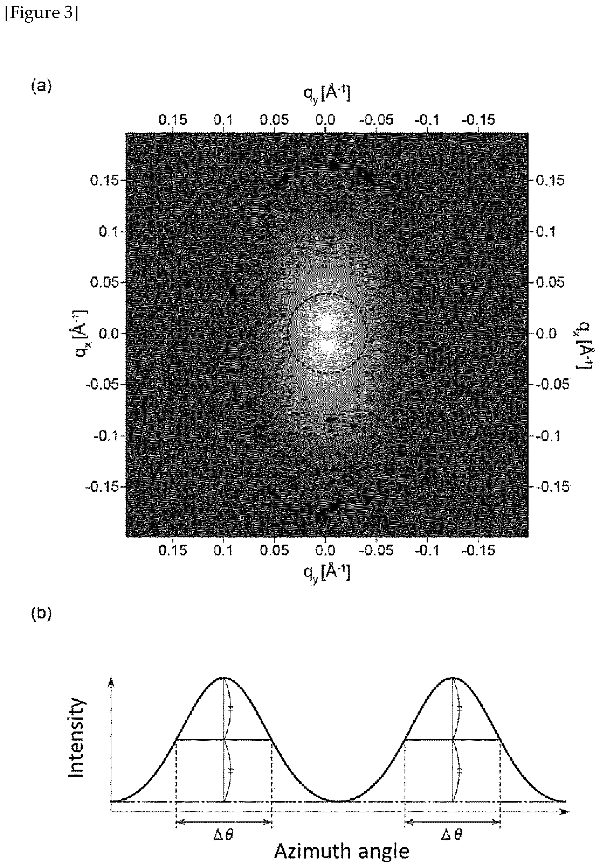

Fig. 3(a) is a diagram illustrating one example of a two-dimensional scattering image of a scattering vector q of a plurality of CNT aggregates 11 by small-angle X-ray scattering (SAXS); and Fig. 3(b) is a graph illustrating one example of an azimuth plot illustrating the relationship of an azimuth angle - scattering intensity of an arbitrary scattering vector q the origin of which is the position of a transmission X-ray in the two-dimensional scattering image.

SAXS is suitable for evaluating a structure or the like of a size of several nm to several tens of nm. For example, by analyzing information on an X-ray scattering image by the following method using SAXS, it is possible to evaluate the orientation of a CNT 11a of an outer diameter of several nm and the orientation of a CNT aggregate 11 of an outer diameter of several tens of nm. For example, when an X-ray scattering image is analyzed with respect to the CNT wire 10, as shown in Fig. 3(a), q_{y} which is the y-component of a scattering vector q (q = 2π/d; d is the lattice spacing) of the CNT aggregate 11 is distributed over a smaller area than qₓ which is the x-component thereof. Further, the azimuth plot of SAXS was analyzed with respect to the CNT wire 10 which is the same as that of Fig. 3(a), with the result that the full-width at half maximum Δθ in azimuth angle in the azimuth plot shown in Fig. 3(b) is 48°. From these analysis results, it may be said that in the CNT wire 10, the plurality of CNTs 11a and the plurality of CNT aggregates 11 have a satisfactory orientation. In this way, the plurality of CNTs 11a and the plurality of CNT aggregates 11 have a satisfactory orientation, so that the heat of the CNT wire 10 is easily dissipated while being smoothly transmitted along the longitudinal direction of the CNT 11a and the CNT aggregate 11. Thus, by adjusting the orientation of the CNT 11a and the CNT aggregate 11, it is possible to adjust the heat dissipation route over the longitudinal direction and the sectional direction of the diameter of the CNT wire 10, so that the CNT wire 10 exerts superior heat dissipation characteristics as compared with a metal core wire. The orientation means an angular difference of the vector of the inner CNTs and CNT aggregates with respect to the vector V in the longitudinal direction of the twisted wire formed by twisting CNTs together.

From the viewpoint of improving the heat dissipation characteristics of the CNT wire 10 by obtaining an orientation of a fixed level or more shown by the full-width at half maximum Δθ in azimuth angle in azimuth plot based on small-angle X-ray scattering (SAXS) indicating an orientation of the plurality of CNT aggregates 11, the full-width at half maximum Δθ in azimuth angle is preferably 60° or less, and more preferably, 30° or less.

Hereafter, the arrangement structure and density of the plurality of CNTs 11a forming the CNT aggregate 11 will be described.

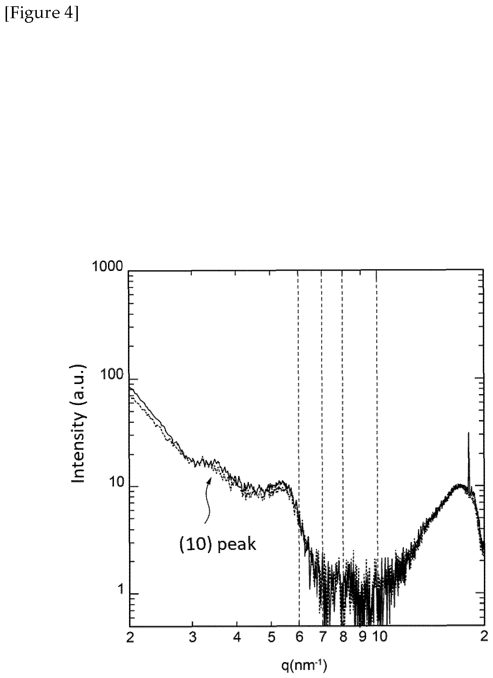

Fig. 4 is a graph illustrating relationship between the q value and intensity by WAXS (wide angle X-ray scattering) of the plurality of CNTs 11a forming the CNT aggregate 11.

WAXS is suitable for evaluating the structure, etc. of a substance of a size of several nm or less. For example, by analyzing an X-ray scattering image information by the following method using WAXS, it is possible to evaluate the density of a CNT 11a the outer diameter of which is several nm or less. As the result of analyzing the relationship between scattering vector q and intensity with respect to an arbitrary CNT aggregate 11, it is possible to measure the value of the lattice constant estimated from the q value of peak top of (10) peak to be found around q = 3.0 nm⁻¹ to 4.0 nm⁻¹ as shown in Fig. 4. Based on the measurement value of this lattice constant and the diameter of the CNT aggregate observed through Raman spectroscopy, TEM or the like, it is possible to confirm that the CNTs 11a form a hexagonal closest packing structure in plan view. Thus, it may be said that within the CNT wire 10, the diameter distribution of a plurality of CNT aggregates is narrow, with the plurality of CNTs 11a being regularly arranged, that is, exhibiting high density, whereby they exist in high density forming a hexagonal closest packing structure.

In this way, a plurality of CNT aggregates 11 have a satisfactory orientation, and, further, the plurality of CNTs 11a forming the CNT aggregate 11 are aligned regularly and arranged at high density, so that the heat of the CNT wire 10 is easily dissipated while being smoothly transmitted along the longitudinal direction of the CNT aggregate 11. Thus, by adjusting the alignment structure and density of the CNT aggregate 11 and the CNT 11a, the CNT wire 10 allows adjustment in the heat dissipation route in the longitudinal direction and the diameter sectional direction, so that it exerts superior heat dissipation characteristics as compared with a metal core wire.

From the viewpoint of further improving the heat dissipation characteristics by attaining high density, the peak top q value at (10) peak of scattering intensity based on X-ray scattering indicating the density of the plurality of CNTs 11a is preferably 2.0 nm⁻¹ or more and 5.0 nm⁻¹ or less, and the full-width at half maximum Δq (FWHM) is preferably 0.1 nm⁻¹ or more and 2.0 nm⁻¹ or less.

The orientation of the CNT aggregate 11 and the CNTs 11a and the alignment structure and density of the CNT 11a can be adjusted by appropriately selecting the spinning method including dry spinning and wet spinning and the spinning condition of the spinning method, described below.

Hereafter, the insulating coating layer 21 coating the outer surface of the CNT wire 10 will be described.

The insulating coating layer 21 has an identification mark (not shown) on a part or the whole of the outer surface thereof, or inside the insulating coating layer 21. As the material of the insulating coating layer 21, it is possible to use a material used for the insulating coating layer of a coated electric wire using metal as the core wire, such as thermoplastic resin. Examples of the thermoplastic resin include polytetrafluoroethylene (PTFE), polyethylene, polypropylene, polyacetal, polystyrene, polycarbonate, polyamide, polyvinyl chloride, polyvinyl acetate, polyurethane, polymethyl methacrylate, acrylonitrile butadiene styrene resin, and acrylic resin. These may be used singly or in a mixture of two or more kinds as appropriate.

As shown in Fig. 1, the insulating coating layer 21 may have one layer or, instead, two or more layers. Further, as needed, a thermosetting resin layer may be provided between the outer surface of the CNT wire 10 and the insulating coating layer 21.

The insulating coating layer 21 may be opaque or transparent. In the case where a transparent insulating coating layer is formed and where an identification mark including a fluorescent substance is imparted to the outer surface of the insulating coating layer, due to the contrast with the black color of the CNT wire, the fluorescent light of the identification mark can be accurately detected and recognized. Such a coated carbon nanotube electric wire is suitable for use in an environment in the background of which there is scarcely any light, for example, as a submarine cable, an underground cable, or a space cable. Further, it is suitable for an aircraft cable used in an aircraft performing nocturnal or marine repairing.

For example, it is applicable to the following coated CNT electric wires.
(a) A coated CNT electric wire 1, wherein the refractive index n_{D} of the material forming the insulating coating layer 21 is less than 1.5; and the film thickness of the insulating coating layer 21 divided by a wire diameter of the CNT wire 10 is less than 0.2, and
(b) A coated CNT electric wire 1, wherein the total luminous transmittance specified in JIS 7375:2008 of the material forming the insulating coating layer 21 is less than 90%; and the film thickness of the insulating coating layer 21 divided by a wire diameter of the CNT wire 10 is less than 0.2.

In the case of the example (b), it is preferable for the total luminous transmittance specified in JIS 7375:2008 to be 75% or less. The refractive index n_{D} and the total luminous transmittance of the material forming the insulating coating layer 21 are within the abovementioned ranges, whereby it is possible to attain a more satisfactory identifiability for the identification mark.

Further, the film thickness of the insulating coating layer 21 divided by the wire diameter of the CNT wire 10 is less than 0.2, whereby it is possible to attain a more satisfactory identifiability for the identification mark. The film thickness of the insulating coating layer 21 and the wire diameter of the CNT wire 10 can be calculated by averaging information obtained by using an image obtained through observation by SEM or an optical microscope of the section of the coated CNT electric wire with respect to the same section in the radial direction of every 10 cm portion in the longitudinal direction of a coated CNT electric wire 1 that is 1.0 m long.

Hereafter, an example of the method of producing the coated CNT electric wire 1 according to an embodiment of the present invention will be described. The coated CNT electric wire 1 can be produced by first producing CNTs 11a, forming the CNT wire 10 from a plurality of CNTs 11a obtained, and coating the peripheral surface of the CNT wire 10 with the insulating coating layer 21.

The CNT 11a can be prepared by a method such as a floating catalyst method (specification of Japanese Patent Publication No. 5819888) and a substrate method (specification of Japanese Patent Publication No. 5590603). The element wire of the CNT wire 10 can be prepared by dry spinning (specification of Japanese Patent Publication No. 5819888, specification of Japanese Patent Publication No. 5990202, specification of Japanese Patent Publication No. 5350635), wet spinning (specification of Japanese Patent Publication No. 5135620, specification Japanese Patent Publication No. 5131571, specification of Japanese Patent Publication No. 5288359), liquid crystal spinning (Japanese Laid-Open Patent Publication No. 2014-530964) or the like.

As the method of coating the peripheral surface of the CNT wire 10 obtained as described above with the insulating coating layer 21, it is possible to adopt a method in which a core wire of aluminum, copper or the like is coated with an insulating coating layer. For example, the thermoplastic resin which is the material of the insulating coating layer 21 is melted, and extruded around the CNT wire 10 to coat the same.

The coated CNT electric wire 1 according to an embodiment of the present invention can be used as a general electric wire such as a wire harness, and a cable may be prepared from a general electric wire using the coated CNT electric wire 1.

### 2. Identification Mark

The insulating coating layer of the coated carbon nanotube electric wire of one embodiment has an identification mark. The identification mark is provided on at least a part of the outer surface where the insulating coating layer is exposed or inside the same. The identification mark may serve to identify the kind, use, or condition (e.g., normal condition and abnormal condition) of the coated carbon nanotube electric wire. Further, specific information such as information on the electric wire itself or information related to the electric wire may be imparted to the identification mark. There are no particular restrictions regarding the material of the identification mark so long as it can be identified by an electromagnetic wave of a specific wavelength such as light that can be identified visually, by binoculars, or by visible light or other light, magnetism, etc.

For example, the identification mark may be one which is situated at a part of the outer surface of the insulating coating layer and which is of a color different from that of the portion other than the identification mark on the outer surface of the insulating coating layer. In this case, specific information may be imparted to the identification mark by varying the configuration of the identification mark (e.g., an annular configuration) in addition to the color of the identification mark.

Further, the identification mark may be an identification mark of the single color situated on the entire outer surface of the insulating coating layer. In this case, there are no particular restrictions regarding the color forming the identification mark. However, it is preferable for the identification mark to be of a color having a visible light wave length, which provides high identifiability even from a distant place. In another example, the color of the identification mark may be a fluorescent color. Further, the carbon nanotube wire is a twisted wire, and the identification mark may be situated, for example, spirally on the outer surface of the insulating coating layer in conformity with the twisting direction, thus indicating the twisting direction of the twisted line.

The identification mark may include a capsule or capsules. There are no particular restrictions regarding the size of the capsule, and examples of the capsule include a micro capsule and a nanocapsule. The capsule or capsules may include a fluorescent substance or an electrically conductive material. The identification mark may be composed of a core portion including a fluorescent substance, and a shell portion including silica. The identification mark may include a tag. The identification mark may include a fluorescent substance carried by a carrier. The identification mark may include a pigment, dye, resin, magnetic material, and a material undergoing a change in color in accordance with a temperature change or a stress change in the coated carbon nanotube electric wire. In the case where the identification mark includes a magnetic material, it is possible to identify the identification mark by magnetism. In the case where an identification mark of a specific color is provided on the outer surface of the insulating coating layer, it is possible to employ a pigment, dye, fluorescent substance or the like as the material of the identification mark. In the following, the materials forming the identification mark will be described in detail.

### (Capsule)

The capsule is, for example, a micro capsule or a nanocapsule having a grain size ranging from several tens of nm to several hundreds of µm. There are no particular restrictions regarding the configuration of the capsule, and it is possible to use, for example, a spherical capsule, an elliptical capsule or the like. Examples of the method of formation into a capsule includes insitu polymerization method, interfacial polymerization method, core cellvation method, spray drying method, dry mixture method, and orifice method.

### (Identification Mark Having Core Portion and Shell Portion)

The core portion of the identification mark is filled with a liquid material, and the liquid material is covered with a shell portion, whereby the liquid material is held in the core portion. Thus, when the liquid material is retained in the core portion, the identification mark has no identifiability, and when the liquid material in the core portion has been discharged, it is possible to exhibit identifiability by virtue of the liquid material. For example, in the case where a micro capsule is used as the identification mark, when high stress or high temperature is applied to the micro capsule, the liquid material is instantaneously discharged from the micro capsule, making it possible to exhibit identifiability in a short time. In the case where the liquid material is discharged from the core portion in a long time, little by little, it is possible to gradually exhibit identifiability.

There are no restrictions regarding the liquid material filling the core portion so long as it is superior in identifiability, and it is possible to employ insulating geland a pigment, dye, fluorescent substance, magnetic material, electrically conductive material and the like described below. Among these liquid materials, it is preferable, in particular, to employ a fluorescent substance as the liquid material since it is superior in identifiability in a dark place or the like. It is preferable for the identification mark to include a core portion including a fluorescent substance and a shell portion including silica. Examples of the identification mark include a fluorescent silica particle. In the case where the identification mark is situated at an end portion of the coated carbon nanotube electric wire, a high stress is applied to the identification mark when the identification mark brings the coated carbon nanotube electric wire into press contact with a terminal. Due to this stress, the electrically conductive material in the identification mark is discharged, and it is possible to make the electrical connection between the coated carbon nanotube electric wire and the terminal a satisfactory one, so that it is preferable to adopt an identification mark including an electrically conductive material.

There are no particular restrictions regarding the material of the shell portion, and it is possible to employ a thermoplastic resin, thermosetting resin or the like. However, it is preferable to employ a thermoplastic resin.

### (Tag)

The identification mark may include a tag. While there are no particular restrictions regarding the tag, it is possible to employ a certification tag such as an IC tag or a barcode tag. It is possible to impart to these tags specific information such as information on the coated carbon nanotube electric wire itself including the kind and use of the coated carbon nanotube electric wire, and information related to the coated carbon nanotube electric wire. In the case where an IC tag is employed, it is possible to read the specific information by an IC chip reader, and to write the specific information by an IC chip writer. In the case where a barcode tag is employed, it is possible to read the specific information by a barcode reader. The tag may be situated on the outer surface of the insulating coating layer or may exist within the insulating coating layer. In the case where the tag is situated inside the insulating coating layer, it is preferable for the insulating coating layer to be transparent or semitransparent.

### (Fluorescent Substance)

The identification mark may include a fluorescent substance. By using a fluorescent substance as the material of the identification mark, it is possible to recognize the coated carbon nanotube electric wire even in a dark place. There are no particular restrictions regarding the fluorescent substance. It may be an organic compound, an inorganic compound, or a semiconductor particle and the like. There are no particular restrictions regarding the fluorescent substance. Examples of the fluorescent substance include C.I. basic red 1, 2, 9, 12, 13, 14, 17, C.I. basic violet 1, 3, 7, 10, 11:1, 14, C.I. acid yellow 73, 184, 250, C.I. acid red 51, 52, 92, 94, C.I. direct yellow 11, 24, 26, 87, 100, 147, C.I. direct orange 26, 29, 29:1, 46, C.I. direct red 1, 13, 17, 239, 240, 242, and 254. Instead of the fluorescent substance, a light absorbing substance may be employed.

As in the case of a conventional coated carbon nanotube electric wire, in the case where a transparent insulating coating layer coating a wire such as a copper wire is formed, and where an identification mark including a fluorescent substance is imparted to the outer surface of the insulating coating layer, when an excitation light is applied from the outside of the coated carbon nanotube electric wire, the copper wire reflects the excitation light, resulting in an increase in background and in deterioration in the visibility of the identification mark. In contrast, as in the case of one embodiment, in the case where a transparent insulating coating layer coating the carbon nanotube wire is formed, and where an identification mark including a fluorescent substance is imparted to the outer surface of the insulating coating layer, since the carbon nanotube wire is black, it is very easy to identify the fluorescent light of the identification mark due to the contrast with the black color. In particular, in the case where the coated carbon nanotube electric wire of one embodiment is used in an environment in a dark condition (e.g., the bottom of the sea, underground, nocturnal navigation area, space, and attic), the visibility and identifiability of the identification mark is markedly superior. Examples of the coated carbon nanotube electric wire used in such a dark condition include a submarine cable, an underground cable, an aircraft cable, and a space cable.

### (Pigment)

While there are no particular restrictions regarding the pigment, it is possible to use, for example, red pigment, blue pigment, green pigment, yellow pigment, orange pigment, violet pigment, or a combination of these pigments. Further, an inorganic pigment and an organic pigment may be used.

Examples of the inorganic pigment include titanium oxide, barium sulfate, calcium carbide, zinc white, lead sulfate, chrome yellow, zinc yellow, blood red (red iron oxide (III)), cadmium red, ultramarine blue, iron blue, chromium oxide green, cobalt green, and umber.

Examples of the organic pigment include anthraquinone type pigment, amino anthraquinone type pigment, quinacridone type pigment, quinacridone quinone type pigment, diketopyrrolopyrrole type pigment, perylene type pigment, perynone type pigment, anthoanthrone type pigment, benzimidazolone type pigment, disazo condensate type pigment, azo type pigment, thioindigo type pigment, pyranthoron type pigment, dioxadine type pigment, quinophthalone type pigment, isoindoline type pigment, and phthalocyanine type pigment.

Further examples of the pigment include carbon black, acetylene black, lamp black, graphite, iron black, aniline black, cyanine black, and titanium black.

By using a pigment as the material of the identification mark, it is possible to improve the visibility of the identification mark.

### (Dye)

While there are no particular restrictions regarding the dye, it is possible to use, for example, red dye, blue dye, green dye, yellow dye, or a combination of these dyes. Examples of the dye include azo type dye, anthraquinone type dye, phthalocyanine type dye, quinoneimine type dye, quinoline type dye, nitro type dye, carbonyl type dye, and methine type dye. By using a dye as the material of the identification mark, it is possible to improve the visibility of the identification mark.

### (Discoloration Material)

In the case where specific characteristics value and physical property value of the coated carbon nanotube electric wire are changed and the coated carbon nanotube electric wire is placed in an abnormal state in which it cannot be used, the identification mark can include a material whose color is changed to a color different from that in the normal state. For example, the identification mark may include a discoloration material whose color is changed in accordance with a temperature change or a pressure change in the coated carbon nanotube electric wire. The discoloration material may be discolored reversibly or irreversibly. That is, in the case where the discoloration material discolors reversibly, it discolors when the coated carbon nanotube electric wire is placed in an abnormal state, and it is restored to the former color when the coated carbon nanotube electric wire is restored to the normal state. On the other hand, in the case where the discoloration material discolors irreversibly, it is discolored when the coated carbon nanotube electric wire is placed in an abnormal state, and remains the same color even when the coated carbon nanotube electric wire is restored to the normal state.

By using an identification mark including a discoloration material whose color is changed in accordance with a temperature change, it is possible to recognize such an abnormal state through visual recognition of the discoloration of the identification mark when the coated carbon nanotube electric wire is placed in a low temperature or high temperature environment in which it cannot be used. Thus, there is no need to directly measure the temperature of the coated carbon nanotube electric wire, and the discoloration can be confirmed even from the distance, so that it is possible to confirm the abnormal state of the coated carbon nanotube electric wire easily and at low cost, making it possible to detect deterioration of the coated carbon nanotube electric wire at an early stage.

Examples of the discoloration material undergoing a change in color in accordance with a temperature change include leuco dye, color-developing substance, pigment containing discoloration temperature adjustment agent, and a capsule obtained by coating these with resin. Examples of the leuco dye include dyphenyl methane phthalides, indolylphthalides, diphenyl methane azaphthalides, phenyl indolyl azaphthalides, fluorans, styrinoquinolines, and diaza rhodamine lactones. It is also possible to adjust the kind of discoloration color and discoloration temperature range by changing the composition of the leuco dye, developing substance, and discoloration temperature adjustment agent.

The adoption of an identification mark including a discoloration material undergoing a change in color in accordance with a change in stress is advantageous as described below. When the coated carbon nanotube electric wire is bent, or when a heavy substance such as snow is placed on the coated carbon nanotube electric wire, and high stress is applied to the coated carbon nanotube electric wire, it is possible to confirm such an abnormal state through visual recognition of discoloration of the identification mark. Thus, there is no need to directly measure the stress applied to the coated carbon nanotube electric wire, and the discoloration can be confirmed even from a distance, so that it is possible to confirm the abnormal state of the coated carbon nanotube electric wire easily and at low cost, and to detect deterioration in the coated carbon nanotube electric wire at an early stage. As compared with a metal wire, CNT is of a very high strength, and there is the possibility of deterioration being preferentially generated around the connection member. Such a change in condition can be recognized through discoloration of the identification mark.

### (Resin)

The identification mark may include a resin. In this case, of the outer surface of the insulating coating layer, the resin forming the identification mark and the material of the portion other than the identification mark are made different from each other, whereby the identification mark and the portion other than that are different in surface nature, color, feel, etc., making it possible to visually recognize the identification mark. As the resin forming the identification mark, it is possible to use both thermoplastic resin and thermosetting resin.

While there are no particular restrictions regarding the thermoplastic resin, examples thereof include polyethylene, polypropylene, polystyrene, polyvinyl chloride, (meth)acrylic resin, vinyl type polymer such as ethylene-vinyl alcohol copolymer and ethylene-vinyl acetate copolymer, polylactate resin, polyester such as polyethylene terephthalate and polybutylene terephthalate, polyamide such as nylon and polyamide amine, polyvinyl acetal resin such as polyvinyl acetoacetal, polyvinyl benzal and polyvinyl buthyral resin, ionomer resin, polyphenylene ether, polyphenylene sulfide, polycarbonate, polyether ether ketone, polyacetal, ABS resin, LCP (liquid crystal polymer), fluororesin, urethane resin, elastomer, and a modified product of these resins.

While there are no particular restrictions regarding the thermosetting resin, examples thereof include phenol resin, urea resin, melamine resin, epoxy resin, unsaturated polyester resin, polyimide, polyurethane, and silicone resin.

### (Magnetic Material)

The identification mark may include a magnetic material. When the identification mark includes a magnetic material, it is possible to identify the identification mark by an apparatus capable of detecting magnetism. While there are no particular restrictions regarding the magnetic material, examples thereof include iron oxide such as magnetite, maghemite, and ferrite, or iron oxide including other metal oxides, metal such as Fe, Co, and Ni, an alloy of these metals and a metal such as Al, Co, Cu, Pb, Mg, Ni, Sn, Zn, Sb, Be, Bi, Cd, Ca, Mn, Se, Ti, W, and V, and a mixture of these substances.

### (Imparting of Information)

Specific information may be imparted to the identification mark. Examples of the "specific information" include information on the electric wire itself and information related to the electric wire. More specifically, the specific information includes the wire diameter, heat conductivity, electric conductivity, use, usable period of the coated carbon nanotube electric wire, which are the characteristics of the coated carbon nanotube electric wire, and information related to the twisting of the carbon nanotube wire. And, for example, the color and configuration and the combination of the color and configuration of the identification mark may be changed in accordance with the characteristics of the coated carbon nanotube electric wire so that the characteristics of the coated carbon nanotube electric wire may be known. Of these characteristics, at least one characteristics value selected from the group consisting of heat conductivity and electric conductivity is important, so that it is preferable to display the value range of these characteristics values through color and configuration or a combination color and configuration of the identification mark. That is, in this case, the identification mark is set in accordance with at least one characteristics value selected from the group consisting of the heat conductivity and electric conductivity of the coated carbon nanotube electric wire. As a result, based on the identification mark, the heat conductivity and electric conductivity of the coated carbon nanotube electric wire can be confirmed easily and reliably.

### (Method of Imparting the Identification Mark)

While there are no particular restrictions regarding the method of imparting the identification mark to the coated carbon nanotube electric wire, examples of the method include:
(a) A method in which the insulating coating layer is formed of a mixture of the material of an identification mark having a predetermined size and configuration and the material of the insulating coating layer other than the material of the identification mark;
(b) A method in which an identification mark is printed on or bonded to the outer surface of the coated carbon nanotube electric wire; and
(c) A method in which chemical reaction is effected between the material of the outer surface of the coated carbon nanotube electric wire and the material of an identification mark, whereby a chemical connection is formed between the material of the outer surface and the material of the identification mark.

In the method (a), there are no particular restrictions regarding the mixture method for obtaining the mixture material, examples of the method include a container rotation type mixture method using ball mill mixture, bead mill mixture, a V-shaped mixture device, a ball container mixer, or the like; a method in which mixture is effected by a mechanical agitation force as in the case of a ribbon mixer; and a method in which agitation mixture is effected through an airflow as in the case of a fluidized layer. By coating the outer surface of the carbon nanotube wire with the mixture material obtained, it is possible to obtain the insulating coating layer. For example, in the case where the entire insulating coating layer constitutes an identification mark of the single color, a pigment, dye, fluorescent substance, or some other coloring agent is mixed with the other material of the insulating coating layer such as a resin material to obtain the mixture material, and then the carbon nanotube wire is coated with the molten mixture material, whereby it is possible to impart the identification mark.

While there are no particular restrictions regarding the method (b) in which the identification mark is printed, examples of the method include a method in which the outer surface of the carbon nanotube wire is coated with the material of the insulating coating layer, and then printing is effected on a part or the whole of the outer surface of the material of the insulating coating layer in an ink including the material of the identification mark. While there are no particular restrictions regarding the ink printing method, examples thereof include ink jet printing, super ink jet printing, screen printing, transfer printing, offset printing, jet printing method, dispenser, jet dispenser, needle dispenser, comma coater, slit coater, dye coater, gravure coater, relief-printing, intaglio printing, gravure printing, soft lithography, dip-pen lithography, spray coater, spin coater, dip coater, and electrodeposition coating. The ink may contain, as needed, solvent, dispersant, surface active agent or the like as the ingredient other than the material of the identification mark.

While there are no particular restrictions regarding the method (b) in which the identification mark is bonded, examples thereof include a method in which a tag or the like is bonded to the outer surface of the coated carbon nanotube electric wire via an adhesive layer.

While there are no particular restrictions regarding the method (c), examples thereof include a method in which the outer surface of the carbon nanotube wire is coated with the material of the insulating coating layer, and then chemical reaction is effected on the outer surface of the material of the insulating coating layer between the material of the insulating coating layer and the material of the identification mark by using an organic peroxide or the like. The organic peroxide is thermally decomposed at a relatively low temperature or reacts with a reducing substance to easily produce a free radical (radical). The nature of this free radical generated is such as to be capable of promoting the addition of the material of the identification mark to an unsaturated double bond in the material of the insulating coating layer, the extraction of hydrogen atoms, etc., and the addition of the material of the identification mark. While there are no particular restrictions regarding the organic peroxide, examples thereof include ketone peroxide, peroxiketal, hydroperoxide, dialkyl peroxide, diacyl peroxide, peroxiester, and peroxydicarbonate.

### (Configuration, Size, and Position of the Identification Mark)

There are no particular restrictions regarding the configuration, size, and position of the identification mark at the insulating coating layer. In accordance with the object of imparting the identification mark, it is possible to determine the configuration, size, and position of the identification mark as appropriate. The configuration of the identification mark may, for example, be a pattern formed by a polygon, circle, a configuration surrounding the periphery of the coated carbon nanotube electric wire, letter, a plurality of colors, etc. There are no particular restrictions regarding the size of the identification mark so long as it is of a size occupying a portion of the insulating coating layer. Preferably, the identification mark is situated at least one end portion in the longitudinal direction of the coated carbon nanotube electric wire on the outer surface of the insulating coating layer. Preferably, the identification mark has an annular configuration encircling the outer surface of the insulating coating layer. In this case, specific information may be imparted to the identification mark by making the identification mark of the annular configuration in a specific color.

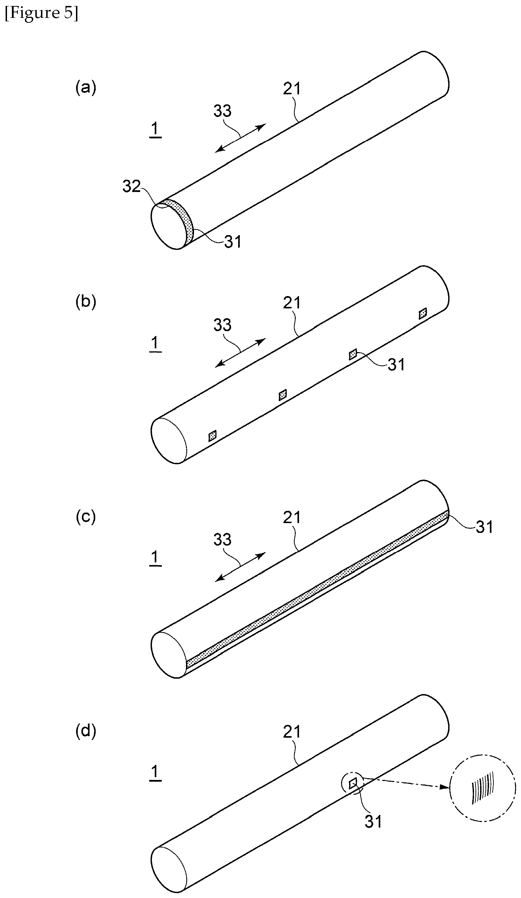

Figs. 5(a) through 5(d) are schematic views illustrating the coated CNT electric wire 1 having the identification mark. Figs. 5(a) through 5(d) are schematic views representing solely the outer surface of the insulating coating layer, and the inner structure of the coated CNT electric wire 1 is omitted.

Fig. 5(a) shows an example in which the identification mark 31 is situated at at least one end portion 32 in the longitudinal direction 33 of the coated CNT electric wire 1 on the outer surface of the insulating coating layer 21. The identification mark 31 may be situated at one end portion 32 of the insulating coating layer 21 or at either end portion thereof. In Fig. 5(a), the identification mark 31 including nanocapsule(s) having an electric conductive material is situated at the end portion 32, whereby, when the coated CNT electric wire 1 is brought into press contact with a terminal, high stress is applied to the nanocapsule(s). Due to this stress, the electric conductive material in the nanocapsule(s) is discharged, realizing a satisfactory electrical connection between the coated CNT electric wire 1 and the terminal. In this case, the electric conductive material functions as an electric conduction aiding agent. By adjusting the color and density of the nanocapsule(s) situated at the end portion 32, it is possible to adjust the visibility of the identification mark 31 and to impart specific information to the identification mark 31.

Fig. 5(b) shows an example in which the identification mark 31 is situated at a fixed interval in the longitudinal direction 33 of the coated CNT electric wire 1 on the outer surface of the insulating coating layer 21. In Fig. 5(b), it is possible, for example, to use the identification mark 31 as a length mark for recognizing the length of the coated CNT electric wire 1.

Fig. 5(c) shows an example in which there is provided an identification mark 31 extending from the first end portion to the second end portion in the longitudinal direction 33 of the coated CNT electric wire 1 on the outer surface of the insulating coating layer 21. That is, the identification mark 31 is provided between both end portions continuously along the longitudinal direction 33. For example, Fig. 5(c) includes an embodiment in which the identification mark 31 includes a material undergoing a change in color in accordance with a temperature change or a stress change in the coated CNT electric wire 1. In this embodiment, in the case where a specific portion of the coated CNT electric wire 1 deteriorates by being placed in a low temperature or high temperature environment or by being subjected to high stress, solely the identification mark 31 situated at the specific portion exhibits a color different from the color of the other portion of the identification mark 31. Thus, it is possible to detect a deteriorated portion of the coated CNT electric wire 1 at an early stage and to cope with the same.

Fig. 5(d) shows an example in which a barcode is provided as the identification mark 31 on the outer surface of the insulating coating layer 21 and in which it is possible to impart specific information related to the coated CNT electric wire 1 to the barcode.

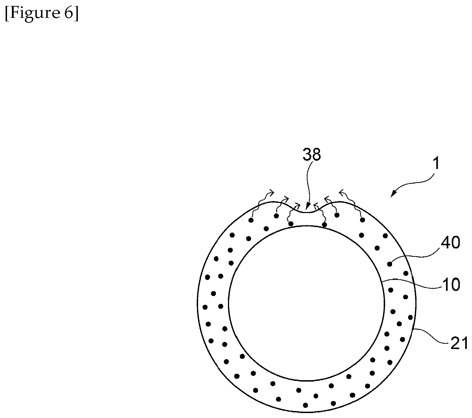

Fig. 6 is a schematic view of another coated CNT electric wire 1 having an identification mark. It is a sectional view of the coated CNT electric wire 1 as seen in a section perpendicular to the longitudinal direction thereof. In Fig. 6, the CNT wire 10 is a twisted wire, which is shown schematically. As shown in Fig. 6, the insulating coating layer 21 contains nanocapsules 40 as the identification mark, and the core portion of the nanocapsules 40 is filled with a fluorescent substance. In the case where the insulating coating layer 21 is thinned through friction or the like to generate a thin film portion 38, a large stress is also applied to the nanocapsules 40 situated in the vicinity of the thin film portion 38, and the fluorescent substance is discharged from the nanocapsules 40 and flows along the twisting direction of the CNT wire 10. The thin film portion 38 has a concave configuration, so that the fluorescent substance eventually remains at this thin film portion 38. As a result, the thin film portion exhibits a marked identifiability, making it possible to detect the generation of the thin film portion 38 at an early stage.

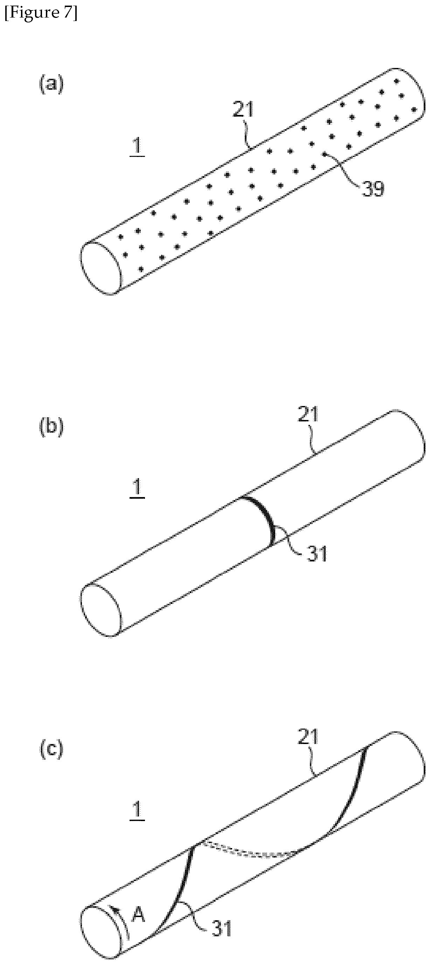

Figs. 7(a) through 7(c) are schematic views of another coated CNT electric wire 1 having an identification mark. In Figs. 7(a) through 7(c), the inner structure of the coated CNT electric wire 1 is omitted, and the outer surface of the insulating coating layer 21 is indicated by a dotted line.

In the coated CNT electric wire 1 of Fig. 7(a), a fluorescent substance 39 is distributed over the entire insulating coating layer 21. By increasing the amount of the fluorescent substance 39, substantially the entire insulating coating layer 21 exhibits a fluorescent property, making it possible to provide a coated CNT electric wire 1 exhibiting a very high identifiability in a dark place.

Fig. 7(b) shows an example in which the identification mark 31 has an annular configuration encircling the outer surface of the insulating coating layer 21. By varying the line width and color of this identification mark 31, it is possible to impart specific information to the identification mark 31. For example, in the case where the CNT wire (not shown) is a twisted wire, the degree of twisting can be recognized through the line width, color, etc. of the identification mark 21.

Fig. 7(c) shows an example in which the identification mark 31 is spirally situated on the outer surface of the insulating coating layer 21. This identification mark 31 is imparted so as to make a spiral round around the outer surface of the insulating coating layer 21, so that the diameter (thickness) of the coated CNT electric wire 1 can be easily recognized even from a distance. In the case where the CNT wire (not shown) is a twisted wire, by imparting a spiral identification mark along the twisting direction, it is possible to recognize the twisting direction of the twisted wire. In particular, in the case where the insulating coating layer 21 is opaque, it is difficult to recognize the twisting direction of the twisted wire from the outside, so that this identification mark 31 proves useful.

### (Uses of the Coated Carbon Nanotube Electric Wire)

Uses of the coated carbon nanotube electric wire can be selected as appropriate depending on the configuration, size, position, material of the identification mark and the material, diameter, characteristics of the carbon nanotube wire, etc. For example, in the case where the insulating coating layer is transparent and where identification mark includes a fluorescent substance, the coated carbon nanotube electric wire can be a submarine cable, underground cable, aircraft cable, or space cable. The bottom of the sea, underground, nocturnal navigation area, space, attic, etc. are dark places, where it is difficult to visually recognize a conventional identification mark. However, in the case where the identification mark of the present embodiment includes a fluorescent substance, it is possible to easily emit fluorescent light by an excitation light source. Further, the carbon nanotube wire is of black color, and its environment is dark, so that through contrast with this, the visibility of the fluorescent light emitted from the identification mark is improved, and the identification mark can exhibit superior visibility and identifiability when used at the bottom of the sea, in underground, in nocturnal flight area, in space, in an attic or the like. The identification mark may be provided continuously over the entire coated carbon nanotube electric wire along the longitudinal direction thereof, or solely at a part thereof.

Examples of the submarine cable include a power cable and a communication cable, and it is possible to use various kinds of submarine cable from a cable for relatively lower pressure for use at a water depth of several tens of meters to a cable for ultrahigh pressure in conformity with a water depth of several hundreds to several thousands of meters. In the case of an ultrahigh pressure submarine cable, the insulating coating layer is of such a structure as can sufficiently protect the carbon nanotube wire from ultrahigh pressure.

Examples of the underground cable include a power cable and a communication cable, and it is possible to use various kinds of underground cable from a cable for a depth of several meters to a cable for a depth of approximately several tens to several hundred meters. In the case of an underground cable laid deep underground, the insulating coating layer is of such a structure capable of sufficiently protecting the carbon nanotube wire.

Examples of the aircraft cable include a power cable and a communication cable used inside and outside an aircraft. Usually, the aircraft cable provided for aircraft is in a severe environment in terms of temperature, air pressure, humidity, etc. However, as compared with a metal wire, the carbon nanotube wire is less subject to corrosion, so that it can exhibit high durability even under such a condition.

Examples of the space cable include a power cable and a communication cable used inside and outside a rocket, space ship, artificial satellite or the like. The space cable provided in a rocket, space ship, artificial satellite or the like is under a very severe condition in terms of cosmic rays, temperature, etc in space environment. Thus, the insulating coating layer is of such a structure as to be capable of sufficiently protecting the carbon nanotube wire even under such a very severe condition.

### 3. Method of Producing the Coated Carbon Nanotube Electric Wire

A method of producing the coated carbon nanotube electric wire according to one embodiment includes a step in which the coated carbon nanotube electric wire including a twisted wire of two or more carbon nanotube wires including one or a plurality of carbon nanotube aggregates formed by a plurality of carbon nanotubes, an insulating coating layer coating the carbon nanotube wire, and an identification mark indicating the twisting direction of the twisted wire on the outer surface of the insulating coating layer, is twisted in the twisting direction indicated by the identification mark.

For example, in the case where there is prepared, as shown in Fig. 7(c), a coated CNT electric wire 1 equipped with a twisted wire of carbon nanotube wires and an insulating coating layer 21, and having an identification mark 31 on the outer surface where the insulating coating layer 21 is exposed, the identification mark 31 indicates the twisting direction of the twisted wire. Thus, by fixing one end of the coated CNT electric wire 1 of Fig. 7(c) in position, and by twisting another end in the direction of the arrow A, it is possible to enhance the strength of the twisted state of the twisted wire of the CNT wire to make the twisted wire less subject to breakage. On the other hand, in the case where no identification mark indicating the twisting direction exits as in the conventional coated CNT electric wire and where the coated CNT electric wire is twisted in a direction reverse to the twisting direction, the twisting of the twisted wire is restored to the former state, and the CNT wire comes loose to become subject to breakage.

### 4. Method of Detecting the Identification Mark

A method of detecting the identification mark according to one embodiment has a step in which light is applied to the coated carbon nanotube electric wire including a twisted wire of two or more carbon nanotube wires including one or a plurality of carbon nanotube aggregates formed by a plurality of carbon nanotubes, an insulating coating layer coating the carbon nanotube wire, and an identification mark indicating the twisting direction of the twisted wire on the outer surface of the insulating coating layer and including a fluorescent substance, and the fluorescent light emitted from the fluorescent substance is detected, whereby the identification mark is detected.

In the identification mark detecting method according to one embodiment, the fluorescent light of the identification mark is accurately detected through contrast with the black color of the carbon nanotube wire, making it possible to accurately recognize the twisting direction of the twisted wire. This detection method is suitable for use in an environment in which scarcely any light enters the background, for example, the detection of the identification mark at the bottom of the sea, underground, in space or the like. It is also suitable for the detection of the identification mark in aircraft in which nocturnal or marine repairing is performed. Typically, the identification mark indicating the twisting direction of the twisted wire is spirally situated on the outer surface of the insulating coating layer. Thus, in this case, it is detected as a spiral fluorescent light. While there are no particular restrictions regarding the kind of fluorescent substance, it is possible to employ the abovementioned fluorescent substances. The light source applied can be selected as appropriate according to the kind of fluorescent substance, the fluorescent wavelength, etc. For example, it is possible to adopt a mercury lamp, a xenon lamp or the like. The fluorescent light detector for detecting the fluorescent light emitted from the fluorescent substance can be selected as appropriate from among well-known fluorescent light detectors in accordance with the fluorescent light wavelength, etc.

### Examples

### (Example 1)

A material solution containing decahydronaphthalene which is a carbon source, ferrocene which is a catalyst, and thiophene which is a reaction accelerator, was supplied through spraying into an alumina pipe of an inner diameter of φ60 mm and a length of 1600 mm heated to 1300°C by an electric furnace of a CNT producing apparatus and produced by using a catalytic chemical vapor deposition (CCVD). As a carrier gas, hydrogen was supplied at a rate of 9.5 L/min. The generated CNT was recovered by being continuously taken up to obtain a CNT wire of a diameter of approximately 100 µm and a length of 75 m. Thereafter, the obtained CNT wire was heated to 500°C under the atmosphere, and was subjected to an acid treatment for higher purification. Thereafter, nitric acid doping was applied on the high purity CNT wire. Thereafter, a plurality of CNT wires were bundled together, and one end of the bundled was fixed. In this state, the other end of the bundle was twisted, whereby a twisted wire was obtained. Thereafter, a thermoplastic resin (polytetrafluoroethylene) was melted and was extruded around the CNT wire by using an extruder, whereby there was obtained a coated CNT electric wire in which the outer surface of the CNT wire was coated with a transparent insulating coating layer of a thickness of 100 µm. Thereafter, by using a printer for imparting an identification mark, the annular identification mark 31 was imparted to the peripheral surface of the insulating coating layer 21 as shown in Fig. 7(b).

### (Example 2)

In the same way as in example 1, there was obtained a coated CNT electric wire in which the outer surface of the CNT wire was coated with a transparent insulating coating layer 21 of a thickness of 100 µm. Thereafter, by using a printer for imparting an identification mark, a spiral identification mark indicating the twisting direction of the CNT wire was imparted to the outer surface of the insulating coating layer 21. As the material of the identification mark, anthraquinone dye was used. Based on this identification mark, it was possible to check the twisting direction of the CNT wire.

### (Example 3)

One end of the coated CNT electric wire having the spiral identification mark obtained in example 2 was fixed, and, in this state, the other end thereof was twisted in the twisting direction indicated by the identification mark.

### (Example 4)

The coated CNT electric wire having a spiral identification mark obtained in example 2 was placed in a dark place, and light was applied to the outer surface of the coated CNT electric wire by an excitation light source. As a result, the identification mark based on the spiral fluorescent light was clearly recognized through visual inspection, and it was possible to accurately recognize the twisting direction of the twisted wire.

### List of Reference Signs

1 coated carbon nanotube electric wire
10 carbon nanotube wire
11 carbon nanotube aggregate
11a carbon nanotube
21 insulating coating layer
31 identification mark
32 end portion
33 longitudinal direction

## Claims

1. A coated carbon nanotube electric wire comprising: a carbon nanotube wire including one or a plurality of carbon nanotube aggregates formed by a plurality of carbon nanotubes; and an insulating coating layer coating the carbon nanotube wire,
wherein:
the insulating coating layer has an identification mark,
the carbon nanotube wire is a twisted wire,
the identification mark indicates a twisting direction of the twisted wire,
the insulating coating layer is present on a peripheral surface of the carbon nanotube wire and is an outermost layer,
the insulating coating layer is transparent, and
the identification mark includes a fluorescent substance.

2. The coated carbon nanotube electric wire according to claim 1, wherein the identification mark is situated at a portion of an outer surface of the insulating coating layer; and
on the outer surface of the insulating coating layer, color of the identification mark is different from color of a portion other than the identification mark.

3. The coated carbon nanotube electric wire according to claim 1 or 2, wherein the identification mark is spirally situated on an outer surface of the insulating coating layer.

4. The coated carbon nanotube electric wire according to claim 1, wherein the identification mark is an identification mark situated on an entire outer surface of the insulating coating layer and having single color.

5. The coated carbon nanotube electric wire according to claim 1 or 2, wherein the identification mark is set in accordance with at least one characteristics value selected from a group consisting of heat conductivity and electric conductivity of the coated carbon nanotube electric wire.

6. The coated carbon nanotube electric wire according to claim 1, 2, or 5, wherein the identification mark includes a capsule or capsules.

7. The coated carbon nanotube electric wire according to any one of claims 1 to 3, wherein
the coated carbon nanotube electric wire is a submarine cable, an underground cable, an aircraft cable, or a space cable.

8. The coated carbon nanotube electric wire according to any one of claims 1, 2, 5 and 6, wherein on an outer surface of the insulating coating layer, the identification mark is situated at at least one end portion in a longitudinal direction of the coated carbon nanotube electric wire.

9. The coated carbon nanotube electric wire according to any one of claims 1, 2, 5 and 6, wherein the identification mark has an annular configuration encircling an outer surface of the insulating coating layer.

10. The coated carbon nanotube electric wire according to any one of claims 1 to 9, wherein a refractive index n_{D} of a material forming the insulating coating layer is less than 1.5, and a film thickness of the insulating coating layer divided by a wire diameter of the carbon nanotube wire is less than 0.2.

11. The coated carbon nanotube electric wire according to any one of claims 1 to 9, wherein a total luminous transmittance of a material forming the insulating coating layer as specified in JIS 7375:2008 is less than 90%, and a film thickness of the insulating coating layer divided by a wire diameter of the carbon nanotube wire is less than 0.2.

12. The coated carbon nanotube electric wire according to any one of claims 1 to 11, wherein the carbon nanotube wire includes the plurality of carbon nanotube aggregates, and a full-width at half maximum Δθ in azimuth angle in azimuth plot based on small-angle X-ray scattering indicating an orientation of the plurality of carbon nanotube aggregates is 60° or less.

13. The coated carbon nanotube electric wire according to any one of claims 1 to 12, wherein a peak top q value at (10) peak of scattering intensity based on X-ray scattering indicating density of the plurality of carbon nanotubes is 2.0 nm⁻¹ or more and 5.0 nm⁻¹ or less, and a full-width at half maximum Δq is 0.1 nm⁻¹ or more and 2.0 nm⁻¹ or less.

14. A method for producing a coated carbon nanotube electric wire comprising: twisting a coated carbon nanotube electric wire including a twisted wire of two or more carbon nanotube wires including one or a plurality of carbon nanotube aggregates formed by a plurality of carbon nanotubes, an insulating coating layer coating the carbon nanotube wires, and an identification mark indicating a twisting direction of the twisted wire on an outer surface of the insulating coating layer in a twisting direction indicated by the identification mark,
wherein the insulating coating layer is present on a peripheral surface of the carbon nanotube wire and is an outermost layer,
the insulating coating layer is transparent, and
the identification mark includes a fluorescent substance.

## Patentansprüche

1. Beschichteter elektrischer Kohlenstoffnanoröhrendraht, umfassend:
einen Kohlenstoffnanoröhrendraht mit einem oder mehreren
Kohlenstoffnanoröhrenaggregaten, die durch mehrere Kohlenstoffnanoröhren gebildet werden; und eine isolierende Überzugsschicht, die den Kohlenstoffnanoröhrendraht beschichtet,
wobei:
die isolierende Überzugsschicht mit einer Identifikationsmarkierung versehen ist,
der Kohlenstoffnanoröhrendraht ein verdrillter Draht ist,
die Identifikationsmarkierung die Verdrillungsrichtung des verdrillten Drahtes angibt,
sich die isolierende Überzugsschicht auf einer peripheren Oberfläche des Kohlenstoffnanoröhrendrahts befindet und eine äußerste Schicht ist,
die isolierende Überzugsschicht transparent ist, und
das Identifikationsmarkierung eine fluoreszierende Substanz enthält.

2. Beschichteter elektrischer Kohlenstoffnanoröhrendraht nach Anspruch 1, wobei sich die Identifikationsmarkierung an einem Teil einer äußeren Oberfläche der isolierenden Überzugsschicht befindet; und
sich auf der Außenfläche der isolierenden Überzugsschicht die Farbe der Identifikationsmarkierung von der Farbe eines anderen Teils als der Identifikationsmarkierung unterscheidet.

3. Beschichteter elektrischer Kohlenstoffnanoröhrendraht nach Anspruch 1 oder 2, wobei die Identifikationsmarkierung spiralförmig auf einer Außenfläche der isolierenden Überzugsschicht angeordnet ist.

4. Beschichteter elektrischer Kohlenstoffnanoröhrendraht nach Anspruch 1, wobei die Identifikationsmarkierung eine Identifikationsmarkierung ist, die sich auf der gesamten Außenfläche der isolierenden Überzugsschicht befindet und eine einzige Farbe hat.

5. Beschichteter elektrischer Kohlenstoffnanoröhrendraht nach Anspruch 1 oder 2, wobei die Identifikationsmarkierung in Übereinstimmung mit mindestens einem Eigenschaftswert gesetzt wird, der aus einer Gruppe ausgewählt wird, die aus Wärmeleitfähigkeit und elektrischer Leitfähigkeit des beschichteten elektrischen Kohlenstoffnanoröhrendrahtes besteht.

6. Beschichteter elektrischer Kohlenstoffnanoröhrendraht nach Anspruch 1, 2 oder 5, wobei die Identifikationsmarkierung eine Kapsel oder Kapseln enthält.

7. Beschichteter elektrischer Kohlenstoffnanoröhrendraht nach einem der Ansprüche 1 bis 3, wobei der beschichtete elektrische Draht aus Kohlenstoffnanoröhren ein Unterseekabel, ein Erdkabel, ein Flugzeugkabel oder ein Weltraumkabel ist.

8. Beschichteter elektrischer Kohlenstoffnanoröhrendraht nach einem der Ansprüche 1, 2, 5 und 6, wobei sich die Identifikationsmarkierung auf einer Außenfläche der isolierenden Überzugsschicht an mindestens einem Endabschnitt in Längsrichtung des beschichteten elektrischen Kohlenstoffnanoröhrendrahtes befindet.

9. Beschichteter elektrischer Kohlenstoffnanoröhrendraht nach einem der Ansprüche 1, 2, 5 und 6, wobei die Identifikationsmarkierung eine ringförmige Konfiguration aufweist, die eine Außenfläche der isolierenden Überzugsschicht umgibt.

10. Beschichteter elektrischer Kohlenstoffnanoröhrendraht nach einem der Ansprüche 1 bis 9, wobei der Brechungsindex no eines Materials, das die isolierende Überzugsschicht bildet, weniger als 1,5 beträgt und die Filmdicke der isolierenden Überzugsschicht geteilt durch den Drahtdurchmesser des Kohlenstoffnanoröhrendrahtes weniger als 0,2 beträgt.

11. Beschichteter elektrischer Kohlenstoffnanoröhrendraht nach einem der Ansprüche 1 bis 9, wobei eine Gesamtlichtdurchlässigkeit eines Materials, das die isolierende Überzugsschicht bildet, wie in JIS 7375:2008 spezifiziert, weniger als 90 % beträgt und eine Filmdicke der isolierenden Überzugsschicht geteilt durch einen Drahtdurchmesser des Kohlenstoffnanoröhrendrahts weniger als 0,2 beträgt.

12. Beschichteter elektrischer Kohlenstoffnanoröhrendraht nach einem der Ansprüche 1 bis 11, wobei der Kohlenstoffnanoröhrendraht eine Vielzahl von Kohlenstoffnanoröhrenaggregaten enthält und eine volle Breite bei halbem MaximumΔθ im Azimutwinkel im Azimutplot auf der Basis von Kleinwinkel-Röntgenstreuung, die eine Orientierung der Vielzahl von Kohlenstoffnanoröhrenaggregaten anzeigt, 60° oder weniger beträgt.

13. Beschichteter elektrischer Kohlenstoffnanoröhrendraht nach einem der Ansprüche 1 bis 12, wobei ein Spitzenwert q am (10) Peak der Streuintensität auf der Grundlage von Röntgenstreuung, die die Dichte der Vielzahl von Kohlenstoffnanoröhren anzeigt, 2,0 nm⁻¹ oder mehr und 5,0 nm⁻¹ oder weniger beträgt, und eine volle Breite beim halben Maximum Δq 0,1 nm⁻¹ oder mehr und 2,0 nm⁻¹ oder weniger beträgt.

14. Verfahren zur Herstellung eines beschichteten elektrischen Kohlenstoffnanoröhrendrahtes, umfassend: Verdrillen eines beschichteten elektrischen Kohlenstoffnanoröhrendrahtes, der einen verdrillten Draht aus zwei oder mehr Kohlenstoffnanoröhrendrähten, die ein oder mehrere Kohlenstoffnanoröhrenaggregate enthalten, die durch mehrere Kohlenstoffnanoröhren gebildet werden, eine isolierende Überzugsschicht, die die Kohlenstoffnanoröhrendrähte beschichtet, und eine Identifikationsmarkierung, die eine Verdrillungsrichtung des verdrillten Drahtes anzeigt, auf einer äußeren Oberfläche der isolierenden Überzugsschicht in einer Verdrillungsrichtung, die durch die Identifikationsmarkierung angezeigt wird, enthält,
wobei die isolierende Überzugsschicht auf einer peripheren Oberfläche des Kohlenstoffnanoröhrendrahtes vorhanden ist und eine äußerste Schicht darstellt,
die isolierende Überzugsschicht transparent ist, und
das Identifikationsmarkierung eine fluoreszierende Substanz enthält.

## Revendications

1. Fil électrique revêtu de nanotubes de carbone comprenant : un fil de nanotubes de carbone comprenant un ou plusieurs d'agrégats de nanotubes de carbone formés par une pluralité de nanotubes de carbone ; et une couche de revêtement isolant recouvrant le fil de nanotubes de carbone,
dans lequel :
la couche de revêtement isolant a une marque d'identification,
le fil de nanotubes de carbone est un fil torsadé,
la marque d'identification indique une direction de torsion du fil torsadé,
la couche de revêtement isolant est présente sur une surface périphérique du fil de nanotubes de carbone et est une couche la plus externe,
la couche de revêtement isolant est transparente, et
la marque d'identification comprend une substance fluorescente.

2. Fil électrique revêtu de nanotubes de carbone selon la revendication 1, dans lequel la marque d'identification est située sur une partie d'une surface externe de la couche de revêtement isolant; et
sur la surface externe de la couche de revêtement isolant, la couleur de la marque d'identification est différente de la couleur d'une partie autre que la marque d'identification.

3. Fil électrique revêtu de nanotubes de carbone selon la revendication 1 ou 2, dans lequel la marque d'identification est située en spirale sur une surface externe de la couche de revêtement isolant.

4. Fil électrique revêtu de nanotubes de carbone selon la revendication 1, dans lequel la marque d'identification est une marque d'identification située sur toute une surface externe de la couche de revêtement isolant et d'une seule couleur.

5. Fil électrique revêtu de nanotubes de carbone selon la revendication 1 ou 2, dans lequel la marque d'identification est définie en fonction d'au moins une valeur caractéristique sélectionnée dans un groupe constitué de la conductivité thermique et de la conductivité électrique du fil électrique revêtu de nanotubes de carbone.

6. Fil électrique revêtu de nanotubes de carbone selon la revendication 1, 2 ou 5, dans lequel la marque d'identification comprend une capsule ou des capsules.

7. Fil électrique revêtu de nanotubes de carbone selon l'une quelconque des revendications 1 à 3, dans lequel
le fil électrique revêtu de nanotubes de carbone est un câble sous-marin, un câble souterrain, un câble d'aéronef ou un câble spatial.

8. Fil électrique revêtu de nanotubes de carbone selon l'une quelconque des revendications 1, 2, 5 ou 6, dans lequel sur une surface externe de la couche de revêtement isolant, la marque d'identification est située sur au moins une partie d'extrémité dans un sens longitudinal du fil électrique revêtu de nanotubes de carbone.

9. Fil électrique revêtu de nanotubes de carbone selon l'une quelconque des revendications 1, 2, 5 et 6, dans lequel la marque d'identification a une configuration annulaire entourant une surface externe de la couche de revêtement isolant.

10. Fil électrique revêtu de nanotubes de carbone selon l'une quelconque des revendications 1 à 9, dans lequel un indice de réfraction no d'un matériau formant la couche de revêtement isolant spécifié est inférieur à 1,5 et une épaisseur de film divisée par un diamètre de fil du fil de nanotubes de carbone est inférieure à 0,2.

11. Fil électrique revêtu de nanotubes de carbone selon l'une quelconque des revendications 1 à 9, dans lequel une transmission lumineuse totale d'un matériau formant la couche de revêtement isolant spécifiée dans le document JIS 7375:2008 est inférieure à 90 % et une épaisseur de film de la couche de revêtement isolant divisé par un diamètre de fil du fil de nanotubes de carbone est inférieure à 0,2.

12. Fil électrique revêtu de nanotubes de carbone selon l'une quelconque des revendications 1 à 11, dans lequel le fil de nanotubes de carbone comprend la pluralité des agrégats de nanotubes de carbone, et la largeur à mi-hauteurΔθ dans l'azimut dans le tracé d'azimut basé sur la diffusion des rayons X aux petits angles indiquant une orientation de la pluralité des agrégats de nanotubes de carbone est inférieure ou égale à 60°.

13. Fil électrique revêtu de nanotubes de carbone selon l'une quelconque des revendications 1 à 12, dans lequel une valeur haute q de pic au pic (10) de d'intensité de diffusion basée sur la diffusion des rayons X indiquant la densité de la pluralité des nanotubes de carbone supérieure ou égale à 2,0 nm⁻¹ et inférieure ou égale à 5,0 nm⁻¹, et une largeur à mi-hauteur Δq est supérieure ou égale à 0,1 nm⁻¹ et inférieure ou égale à 2,0 nm⁻¹.

14. Procédé de production d'un fil électrique en nanotubes de carbone comprenant : la torsion d'un fil électrique en nanotubes de carbone comprenant un fil torsadé d'au moins deux fils de nanotubes de carbone notamment un ou plusieurs agrégats de nanotubes de carbone formés par une pluralité de nanotubes de carbone, une couche de revêtement isolant recouvrant les fils de nanotubes de carbone, et une marque d'identification indiquant une direction de torsion du fil torsadé sur une surface externe de la couche de revêtement isolant dans une direction de torsion indiquée par la marque d'identification,
dans lequel la couche de revêtement isolant est présente sur une surface périphérique du fil de nanotubes de carbone et est une couche la plus externe,
la couche de revêtement isolant est transparente, et
la marque d'identification comprend une substance fluorescente.
